(19)

**Europäisches Patentamt**
**European Patent Office**
**Office européen des brevets**

(11)  **EP 1 684 421 B1**

(12)  **EUROPEAN PATENT SPECIFICATION**

(45) Date of publication and mention
of the grant of the patent:
**02.01.2008  Bulletin 2008/01**

(51) Int Cl.:
*H03H 7/12* (2006.01)          *H03H 9/64* (2006.01)
*H03M 3/00* (2006.01)

(21) Application number: **06002858.6**

(22) Date of filing: **13.11.2002**

(54) **Bandpass sigma-delta modulator with anti-resonance cancellation**

Bandpass-Sigma-Delta-Modulator mit Antiresonanzunterdrückung

Modulateur sigma-delta passe bande à annulation d'anti-resonance

(84) Designated Contracting States:
**AT BE BG CH CY CZ DE DK EE ES FI FR GB GR
IE IT LI LU MC NL PT SE SK TR**

(30) Priority: **13.11.2001  US 331256 P
03.07.2002  US 188071**

(43) Date of publication of application:
**26.07.2006  Bulletin 2006/30**

(62) Document number(s) of the earlier application(s) in
accordance with Art. 76 EPC:
**02786344.8 / 1 454 416**

(73) Proprietor: **NATIONAL UNIVERSITY OF
SINGAPORE
Singapore 119260 (SG)**

(72) Inventors:
• **Xu, Yong Ping
No. 03-02 Singapore 129793 (SG)**
• **Sun, Wai Hoong
No. 04-1840 Singapore 560559 (SG)**
• **Wang, Xiaofeng
Henan Province
China 476000 (CN)**

• **Wang, Zhe
No. 10-101 Singapore 120206 (SG)**
• **Liw, Sean Ian Saxon
No. 09-617 Singapore 400329 (SG)**

(74) Representative: **Klunker . Schmitt-Nilson . Hirsch
Winzererstrasse 106
80797 München (DE)**

(56) References cited:
**US-A- 4 754 242          US-A- 5 499 003**

• **PATENT ABSTRACTS OF JAPAN vol. 2000, no.
19, 5 June 2001 (2001-06-05) -& JP 2001 044790 A
(KYOCERA CORP), 16 February 2001
(2001-02-16)**
• **CHEN, WAI-KAI: "Two-Port Synthesis by Ladder
Development" 1995, THE CIRCUITS AND
FITTERS HANDBOOK 72, CRC PRESS, INC. ,
CHICAGO , XP002254884 ISBN 0-8493-8341-2 *
page 2276 - page 2291 ***
• **PATENT ABSTRACTS OF JAPAN vol. 010, no. 359
(E-460), 3 December 1986 (1986-12-03) -& JP 61
157112 A (TOSHIBA CORP), 16 July 1986
(1986-07-16)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

Technical Field

The present invention relates generally to a bandpass sigma-delta modulator, and more particularly to a bandpass sigma-delta modulator using an acoustic resonator or micro-mechanical resonator. The present invention also generally relates to the cancellation of the anti-resonance signal from a resonator and more particularly to a method and apparatus for cancelling the anti-resonance in micro-mechanical, surface acoustic wave (SAW) and bulk acoustic wave (BAW) resonators.

Background Art

Cellular telephone systems have become very popular in many countries throughout the world. Unfortunately, the specific standards adopted by different countries are often different and cellular devices from one country will not be operable within another system. Accordingly, completely different handsets are necessary if a person is operating in two different countries having different standards.

As a result of this difficulty, there have been some efforts to provide a single device that is operable in different countries having different standards. A technology known as software-defined radio (SDR) provides one solution to this problem. In the SDR system, the entire band of RF or IF signal is digitized and the channel is selected using a programmable digital filter. Thus, the SDR can be reconfigured through the software to suit different standards. However, this effort has not been completely successful because it requires a high-speed A/D converter that must have not only high-speed, but also provide adequate resolution. In the ideal SDR arrangement, the RF is directly digitized in the receiver. It requires that the A/D converter have a speed in the gigahertz range, and also have a dynamic range over a 100 dB, which is equivalent to a 16-bit resolution. Among the various A/D converters, the sigma-delta A/D converter has promise in achieving the desired dynamic range. However, it is only achievable at a much lower frequency band. As the frequency increases, circuit imperfections become dominant and degrade the dynamic range of the A/D converter. At the gigahertz sampling frequency range, the highest dynamic range for the reported bandpass sigma-delta modulator is 75 dB, which only corresponds to a 12.5 bit resolution.

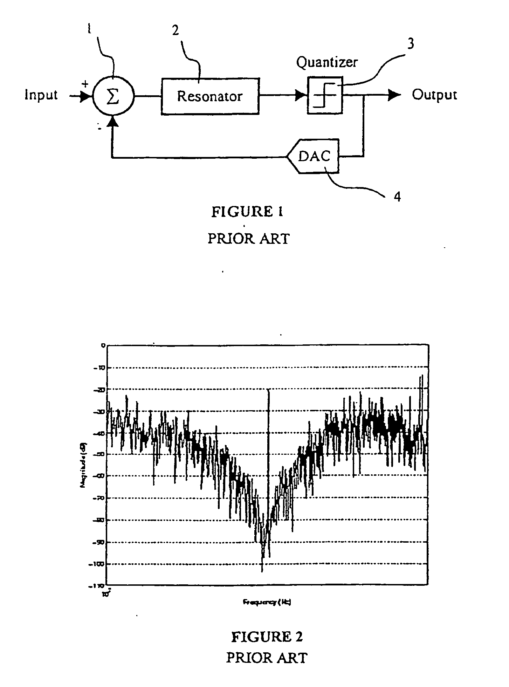

A sigma-delta A/D converter consists of a sigma-delta modulator and a digital filter. Figure 1 shows a typical arrangement of a bandpass sigma-delta modulator. The key element in the modulator is the resonator 2 which provides the quantization noise shaping. That is, the resonator acts as a bandpass filter in a band around its resonance frequency. The resonator needs to operate at a high frequency and have a high Q (quality factor) value. The output of the resonator is passed to a quantizer 3 which produces a digital "1" signal if its input exceeds a threshold and a digital "0" signal if the input is less than the threshold. This digital signal of a series of 0's and 1's becomes the output of the sigma-delta modulator. These signals are also fed back to a D/A converter 4, and the resultant analog signal is applied as a second input to summation device 1 which also receives the input to the modulator. The difference between the input and the feedback of the summation device produces an input to the resonator.

Figure 2 shows a typical output spectrum from a fourth order bandpass sigma-delta modulator where the quantization noise is shaped away from the resonance frequency, resulting in a very high dynamic range. The depth of the notch is related to the Q value of the resonator. The higher the Q value is, the deeper the notch. The noise shaping is also dependent on the order of the modulator. Higher order modulators provide better noise shaping and hence a higher dynamic range.

Typically, the resonator is made of one of three different electronic circuits, namely, a passive L-C tank, a transconductor-capacitor or a switch-capacitor. However, none of these circuits have been successful in the situation described. The first two circuits cannot achieve a high Q value due to parasitic losses and non-linearity. Typical Q values are around 10 and 40 for the integrated L-C tank with and without Q enhancement, respectively. The enhanced Q value for the transconductor-capacitor resonator can be up to 300 at a frequency of several hundred MHz. The switch-capacitor resonator is restricted by its low resonant frequency (< 100 MHz) due to the slow settling behavior of the circuit. The use of these types of resonators prevents the sigma-delta modulator from achieving a high speed and high dynamic range at the same time as is required in an SDR situation. In order to achieve a workable SDR system, it is necessary to find a resonator which is usable in a sigma-delta modulator to achieve high speed and high dynamic range.

In these resonators, there are two modes of resonance, namely the series mode and the parallel mode. In the series mode, the impedance of the resonator is at a minimum. In the parallel mode, the impedance of the resonator is at a maximum. The frequency at which the series resonance occurs is referred to as the resonant frequency while the frequency at which the parallel resonance mode occurs is called the anti-resonant frequency.

Figure 11 is a graph showing the relationship between the frequency of the resonator and the admittance (inverse of impedance). A maximum point is seen at 21 which is the series resonance mode. This occurs at frequency $f_r$. A minimum point 22 is the parallel resonance mode which occurs at the anti-resonance frequency $f_a$.

Figure 12 shows a typical equivalent circuit for a resonator. It includes a static capacitance $C_p$, 23 which is connected in parallel to a series circuit of resistor $R_m$, 26, capacitor $C_m$, 25 and inductor $L_m$, 24. The static ca-

pacitance 23 alters the transfer function of the ideal resonator by introducing two transmission zeros. In different applications, the presence of the anti-resonance may be desirable, such as in filtering and making oscillators. However, in other situations, it is not desirable such as in the sigma-delta modulator of Figure 1 discussed above. The presence of anti-resonance makes it difficult to realize the transfer function of the modulator and therefore it is desirable that it be cancelled. Likewise, in other modulators and in other situations, it may be desirable to cancel the anti-resonance in order that the resonance peak is emphasized.

In this context JP 2001 044790 A, Patent Abstracts of Japan, Vol. 2000, No. 19, discloses a device with a capacitor, which compensates the temperature-related frequency shift of an anti-resonance of a surface acoustic wave resonator, and in which the capacitor is connected parallel to the resonator.

US 4,754,242 discloses a microwave resonator. A plurality of these resonators is magnetically connected to form a filter. The resonator does not show any anti-resonance.

Chen, Wai-Kai discusses in "Two-port synthesis by ladder development", 1995, The Circuits and Fitters Handbook 72, the realization of several transmission functions by different types of ladders.

US 5,499,003 discloses resonant and anti-resonant inter digital transducers, which are coupled on acoustic tracks of a piezoelectric substrate to provide a balanced differential surface acoustic wave filter.

JP 61 157112 A, Patent Abstracts of Japan, Vol. 010, No. 359, discloses an interdigital converter and a capacitance connected in parallel, which leads to a decrease of the resonance/anti-resonance frequency difference.

DISCLOSURE OF INVENTION

An object of this invention is to provide a method for canceling the anti-resonance in resonators.

Another object of this invention is to provide a circuit for the cancellation of anti-resonance in resonators.

A still further object of this invention is to provide a circuit having a resonator and a cancellation network providing inputs to a subtractor.

A still further object of this invention is to provide a capacitor which acts as the cancellation network for a resonator.

Briefly, these and other objects of the invention are achieved by a cancellation network having a common input with a resonator and having an output which is subtracted from the output of the resonator is provided to cancel the anti-resonance.

BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:

Figure 1 is a block diagram of a prior art bandpass sigma-delta modulator.

Figure 2 is a graph of the output spectrum from a typical fourth order modulator.

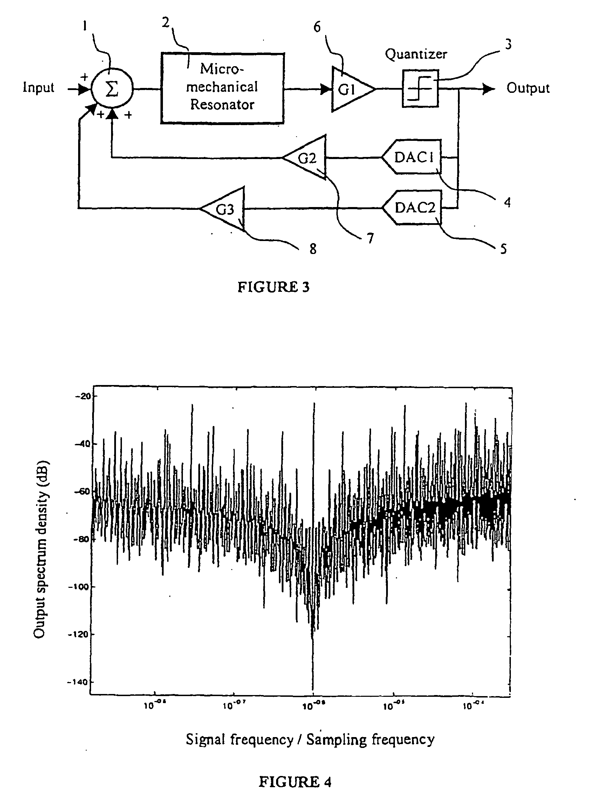

Figure 3 is a block diagram of a second order bandpass sigma-delta modulator using a micro-mechanical resonator according to the present invention.

Figure 4 is a graph of the output spectrum from the second order bandpass sigma-delta modulator of Figure 3.

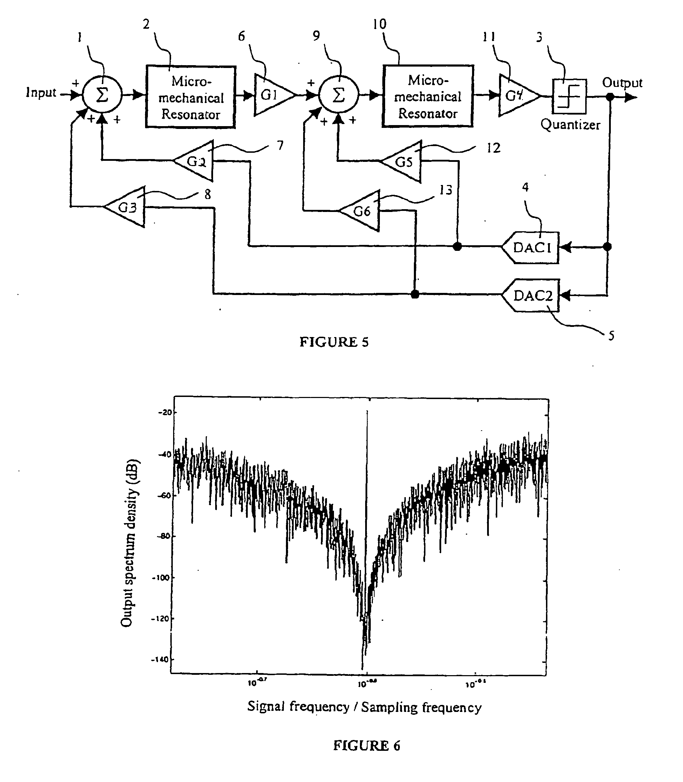

Figure 5 block diagram of a fourth order bandpass sigma-delta modulator using micro-mechanical resonators.

Figure 6 is a graph of the output spectrum from a fourth order bandpass sigma-delta modulator according to Figure 5.

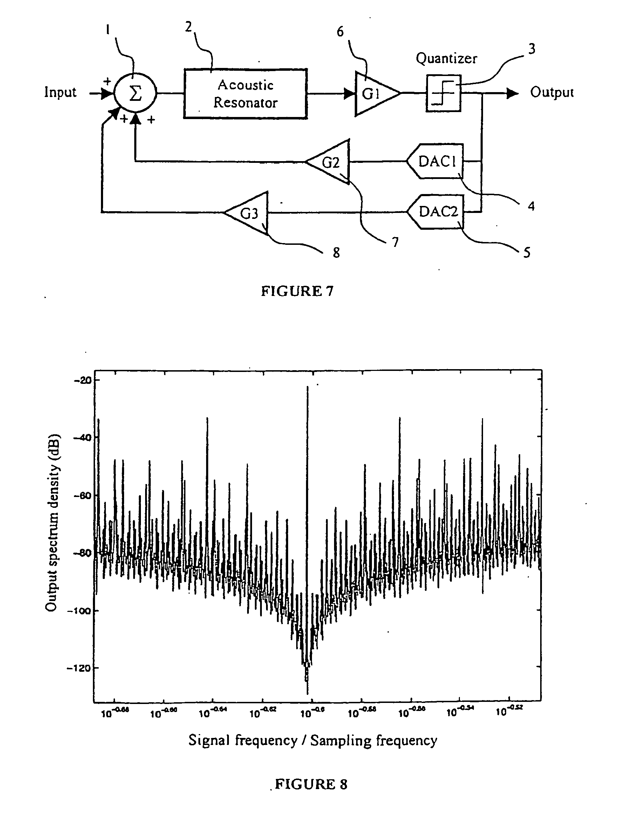

Figure 7 is a block diagram of the second order bandpass sigma-delta modulator using an acoustical resonator.

Figure 8 is a graph of the output spectrum from a second order bandpass sigma-delta modulator shown in Figure 7.

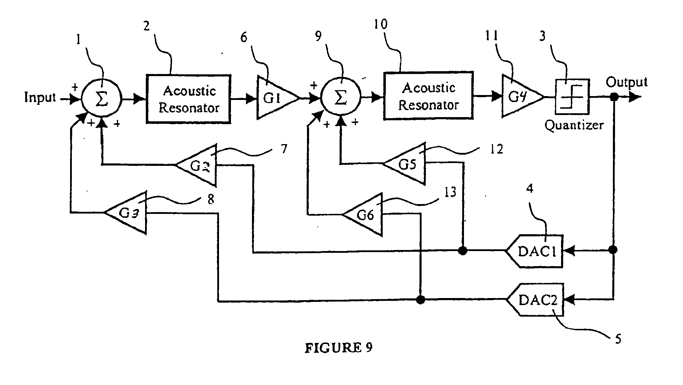

Figure 9 is a block diagram of a fourth order bandpass sigma-delta modulator using acoustical resonators.

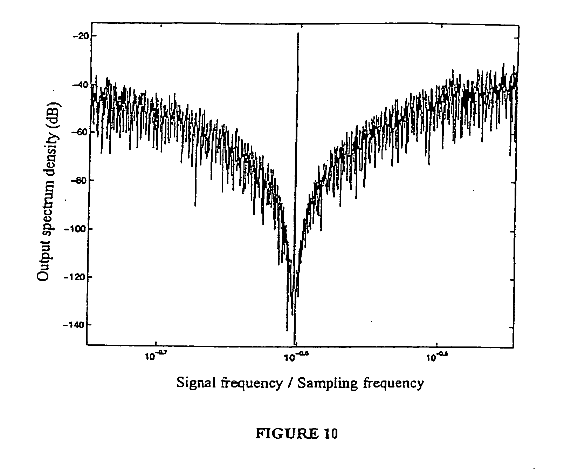

Figure 10 is a graph showing the output spectrum from a fourth order bandpass sigma-delta modulator as shown in Figure 9.

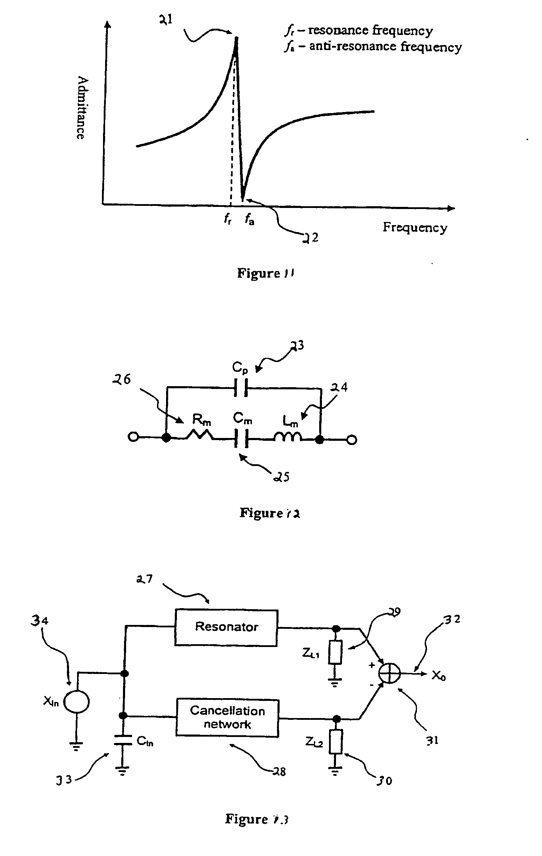

Figure 11 is a graph illustrating the relationship between frequency and admittance of a resonator;

Figure 12 is an equivalent circuit for a prior art resonator;

Figure 13 is a circuit diagram of a first embodiment of the present invention;

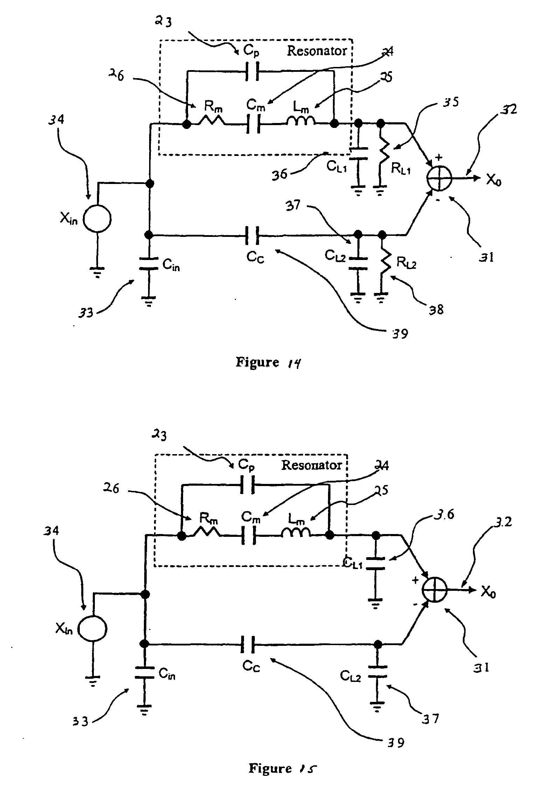

Figure 14 is a detailed circuit diagram of the embodiment shown in Figure 13;

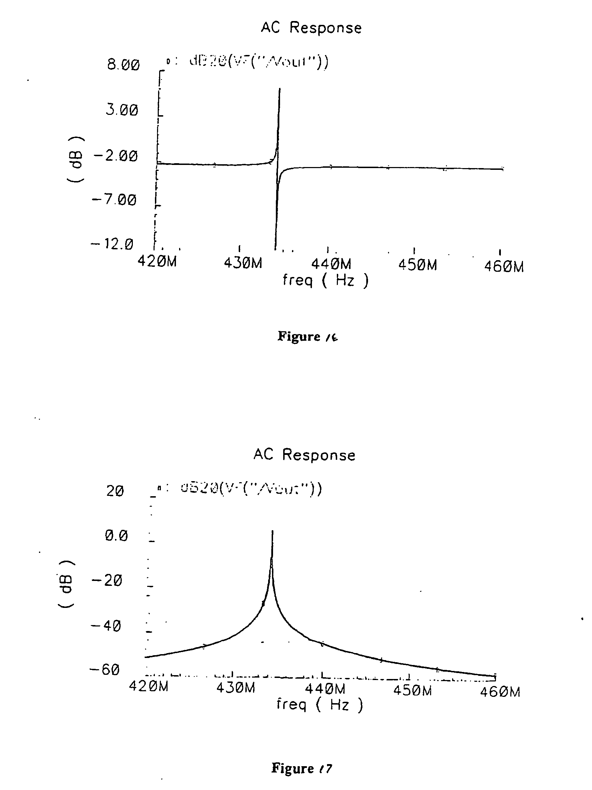

Figure 15 is a detailed circuit diagram of the second embodiment of the present invention;

Figure 16 is a graph of a frequency response for a resonator according to the prior art; and

Figure 17 is a graph of a frequency response for a resonator according to the present invention.

BEST MODES FOR CARRYING OUT THE INVENTION

Referring now to the drawings, wherein like reference numerals designate identical corresponding parts throughout the several views, and more particularly to Figure 3 which shows a second order sigma-delta modulator using a micro-mechanical resonator. The summing circuit 1 adds the analog input to two outputs from two gain stages. The sum forming the output of the summing circuit becomes the input to the micro-mechanical resonator 2. The resonator selectively passes the signal at its resonance frequency and attenuates signals at other frequencies. The output from the resonator is adjusted by gain stage G1, 6 and fed to quantizer 3. The signal is quantized to form a series of binary bits as in Figure 1 which form the output of the modulator. The output is also fed back as an input to a pair of D/A converters, DAC1, 4, and DAC2, 5. The converters are both one bit converters but have different output pulses. One is a return to zero converter, whereas the other is a half return to zero converter. As a result, they have different transfer functions in the frequency domain. The output of the converters are analog signals which are fed back to the summing circuit through gain stages G2, 7 and G3, 8. The value of the gains in G1-G3 may be either positive or negative and often the gains in the feedback path are negative so that the feedback is subtracted from the input signal in a similar fashion to Figure 1.

Since the micro-mechanical resonator 2 is a second order system, the bandpass modulator shown in Figure 3 is of the second order, and provides second order noise-shaping as shown in Figure 4. This modulator based on the micro-mechanical resonator is capable of digitizing the analog input signal, but with a limited resolution. Better resolution can be obtained using a fourth order modulator as will be described below. However, since the Q values of the micro-mechanical resonator can easily be greater than 1000 and even as high as 10,000, it is possible to have a high resonance frequency, up to a gigahertz using this type of resonator. Accordingly, the use of this different resonator allows the modulator to operate at the gigahertz sampling frequency range with good resolution.

Figure 5 illustrates a corresponding fourth order bandpass sigma-delta modulator using a micro-mechanical resonator. Input summing circuit 1 adds the input to the modulator and the feedback from 2 gain stages in a similar fashion to Figure 3. The output of the summing circuit is fed to micro-mechanical resonator 2 which produces an output to gain stage G1, 6. This output is then applied to the second summing circuit 9 along with two additional feedback signals. The sum of these signals is used as the input to the second micro-mechanical resonator 10 which also selectively passes the signal at the resonance frequency and attenuates the signal at other frequencies. This output is adjusted by gain stage G4, 11 and its output is applied to quantizer 3. The output of the quantizer is a series of digital bits as described above and forms the output of the modulator. This output is fed back to two converters D/A converters 4 and 5 in a similar fashion to Figure 3. However, in addition to the analog feedback signal being applied to gain stages G2 and G3 as in Figure 3, they are also applied to gain stages G5, 12, and G6, 13 as inputs to the second summing circuit 9.

The output is the output of a fourth order bandpass sigma-delta modulator having a digitized form of the input analog signal. By having two micro-mechanical resonators in the loop, this device provides fourth order noise-shaping as shown in Figure 6. This fourth order modulator using two micro-mechanical resonators is able to provide digitization of the analog signal with high resolution.

As in the embodiment of Figure 3, the gain stages can be either positive or negative, and either gain or attenuation, as necessary.

Another type of resonator which has superior performance to electronic resonators are acoustic resonators. A surface acoustic wave (SAW) resonator has a resonance frequency of 50 - 2,000 MHz. It also has a Q factor of 4,000 - 15,000. A film bulk acoustic resonator (FBAR) has a resonance frequency of 300 - 10,000 MHz and a Q factor of 100 to 1000. The use of these types of resonators in the bandpass sigma-delta modulator also produces a digital output with high resolution at high frequencies.

Figure 7 shows a bandpass sigma-delta modulator using an acoustic resonator 2. The remaining parts of the circuit operate in a similar fashion to that of Figure 3. Since the acoustic resonator 2 is a second order system, the bandpass sigma-delta modulator shown in Figure 7 is of second order and provides second order noise-shaping as shown in Figure 8. This modulator using an acoustic resonator is capable of digitizing the analog input signal, but with less resolution than a fourth order modulator.

Figure 9 shows such a fourth order bandpass sigma-delta modulator using acoustic resonators. This arrangement is similar to that shown in Figure 5, but uses acoustic resonators rather than micro-mechanical resonators. Since there are two acoustic resonators in the loop, the modulator provides a fourth order noise shaping as shown in Figure 10 and is therefore of fourth order. This fourth order bandpass sigma-delta modulator using acoustic resonators is able to provide the digitization of the analog signal with a high resolution at high frequency.

Figure 13 shows the system with anti-resonance cancellation. An input signal from the signal generator $X_{in}$ 34, is applied to both resonator 27 and cancellation network 28. The output of the cancellation network is subtracted from the output of the resonator circuit in the subtractor 31. Lumped loads $Z_{l1}$, 29 and $Z_{l2}$ 30 are provided at the outputs of the resonator and cancellation network, respectively. These consist of the input impedances of the subtractor as well as parasitic impedances at the respective notes. Capacitor $C_{In}$ 33, is a lumped parasitic capacitance at the input node The output of the subtractor $X_o$, 32, provides a signal with the anti-resonance being removed from the usual resonator output. This is accomplished as long as certain parameters of the cancellation network assume the proper values.

Figure 14 shows a more detailed cancellation circuit of the first embodiment. As shown, the lumped loads 29 and 30 are each replaced by a parallel circuit of a resistor and capacitor. Thus, load 29 is shown as including resistor $R_{L1}$, 35, and capacitor $C_{L1}$, 36. Likewise, load 30 includes resistor $R_{L2}$, 38, and capacitor $C_{L2}$, 37. In this arrangement, the cancellation network is merely a capacitor $C_c$, 39. The resonator 27 includes the equivalent circuit such as shown in Figure 12. In order for the anti-resonance to be cancelled, it is necessary for the following conditions to be met:

$$C_p = C_c, R_{L1} = R_{L2} \text{ and } C_{L1} = C_{L2}.$$

The presence of the parasitic capacitance 33 at the input node has no effect on the cancellation of the anti-resonance.

When these specific relationships are true, the output of the cancellation circuit is applied to the subtracting input of subtractor 31 to remove the anti-resonance part of the output curve from the resonator. Thus, by matching the parameters of the cancellation circuit to the parameters of various parts of the resonator part of the circuit, a signal is produced in the cancellation network which follows the anti-resonance signal. When this is subtracted from the output of the resonator, the anti-resonance part of the output is removed leaving the resonance part of the signal without having any anti-resonance. Thus, the output signal shown in Figure 16 which corresponds to the output of the resonator is then changed in the subtractor to produce an output such is shown in Figure 17 which does not include an anti-resonance.

Figure15 shows a second embodiment where the lumped loads 29 and 30 are purely capacitive and thus, are indicated by capacitors $C_{L1}$,36, and $C_{L2}$,37. In this case, the anti-resonance cancellation can be achieved by the following simple condition:

$$\frac{C_P}{C_{L1}} = \frac{C_C}{C_{L2}}$$

In this case, it is only necessary that the ratio of capacitors $C_p$ to $C_{L1}$ be equal to that of $C_c$ to $C_{L2}$. In this situation, the result is similar to that of the first embodiment shown in Figure 14 and described in Figures 16 and 17.

**Claims**

1. A resonator system, comprising:

a resonator (27) having an input connected to an input signal (34) and an output; and a cancellation network (28) having an input connected to said input signal (34) and having an output; **characterised by**, a subtracter (31) having a positive input connected to the output of said resonator (27) and a negative input connected to the output of said cancellation network (28) and an output: wherein an anti-resonance (22) is removed from the output of said resonator (27).

2. A system according to claim 1, further comprising a first load (29) connected to said output of said resonator (27), and a second load (30) connected to said output of said cancellation network (28).

3. A system according to claim 2, further comprising an input capacitance (33) connected to said input of said resonator (27) and said input of said cancellation network (28).

4. A system according to any one of claim 1, 2 or 3, wherein said cancellation network (28) includes a capacitor (39) connected between said input of said cancellation network (28) and said output of said cancellation network (28).

5. A system according to any one of claims 1 to 4, wherein said capacitor (39) of said cancellation network (28) has a value equal to a static capacitance (23) of said resonator (27) and wherein parameters of said first load (29) and of said second load (30) are equal.

6. A system according to any one of claims 1 to 5 wherein said first load (29) includes a first load capacitor (36) and said second load (30) includes a second load capacitor (37) with capacitances of said first load capacitor (36) and said second load capacitor (37) being equal.

7. A system according to any one of claims 1 to 5, wherein said first load (29) includes a first load resistor (35), said second load (30) includes a second load resistor (38) and resistances of said first load resistor (35) and said second load resistor (38) are equal.

8. A system according to any one of claims 1 to 5, wherein said first load (29) includes only a first load capacitor (36) and said second load (30) includes only a second load capacitor (37) with the ratio of the static capacitor (23) of the resonator (27) to the first load capacitor (36) equaling the ratio of the capacitor (39) of the cancellation network (28) to the second load capacitor (37).

9. The system according to any one of claims 1 to 5, wherein said resonator (27) includes a series circuit of a resistor (26), an inductor (25) and a capacitor (24), said series circuit having a first terminal connected to said Input of said resonator (27) and having a second terminal connected to an output of said resonator (27), said resonator (27) also including a static capacitor (23) connected in parallel with said series circuit between said first terminal and said second terminal.

10. A method for canceling an anti-resonance signal (22), comprising:

providing a resonator circuit (27) having an input and an output;
providing a cancellation network (28) having an input connected to said resonator circuit (27) input and having an output; **characterised by**, subtracting the signal at the output of said cancellation network (28) from the signal at an output of said resonator circuit (27) to produce a subtracter output (32), wherein the subtracter output (32) contains a resonance signal (21) from said resonator without an anti-resonance signal (22).

11. The method according to claim 10, wherein said cancellation network (28) is a capacitor (39).

12. The method according to claims 10, wherein a capacitance (39) of said cancellation network (28) is equal to a static capacitance (23) of said resonator (27).

**Patentansprüche**

1. Resonatorsystem, umfassend:

- einen Resonator (27) mit einem Eingang, welcher mit einem Eingangssignal (34) verbunden ist, und mit einem Ausgang; und
- einem Löschungs-Netzwerk (28) mit einem Eingang, welcher mit dem Eingangssignal (34) verbunden ist, und mit einem Ausgang;

**gekennzeichnet durch**,

- einen Subtrahierer (31) mit einem positiven Eingang, welcher mit dem Ausgang des Resonators (27) verbunden ist, und mit einem negativen Eingang, welcher mit dem Ausgang des Löschungs-Netzwerks (28) verbunden ist, und mit einem Ausgang;
- wobei eine Anti-Resonanz (22) von dem Ausgang des Resonators (27) entfernt wird.

2. System nach Anspruch 1, umfassend weiterhin eine erste Last (29), welche mit dem Ausgang des Resonators (27) verbunden ist, und eine zweite Last (30), welche mit dem Ausgang des Löschungs-Netzwerks (28) verbunden ist.

3. System nach Anspruch 2, weiterhin umfassend eine Eingangs-Kapazität (33), welche mit dem Eingang des Resonators (27) und dem Eingang des Löschungs-Netzwerks (28) verbunden ist.

4. System nach einem der Ansprüche 1, 2 oder 3, wobei das Löschungs-Netzwerk (28) einen Kondensator (39) beinhaltet, welcher mit dem Eingang des Löschungs-Netzwerks (28) und dem Ausgang des Löschungs-Netzwerks (28) verbunden ist.

5. System nach einem der Ansprüche 1 bis 4, wobei der Kondensator (39) des Löschungs-Netzwerks (28) einen Wert besitzt, welcher gleich einer statischen Kapazität (23) des Resonators (27) ist, und wobei Parameter der ersten Last (29) und der zweiten Last (30) gleich sind.

6. System nach einem der Ansprüche 1 bis 5, wobei die erste Last (29) einen ersten Last-Kondensator (36) umfasst und die zweite Last (30) einen zweiten Last-Kondensator (37) umfasst, wobei die Kapazitäten des ersten Last-Kondensators (36) und des zweiten Last-Kondensators (37) gleich sind.

7. System nach einem der Ansprüche 1 bis 5, wobei die erste Last (29) einen ersten Last-Widerstand (35) umfasst und die zweite Last (30) einen zweiten Last-Widerstand (38) umfasst und die Widerstände des ersten Last-Widerstands (35) und des zweiten Last-Widerstands (38) gleich sind.

8. System nach einem der Ansprüche 1 bis 5, wobei die erste Last (29) nur einen ersten Last-Kondensator (36) umfasst und die zweite Last (30) nur einen zweiten Last-Kondensator (37) umfasst, wobei das Verhältnis des statischen Kondensators (23) des Resonators (27) zu dem ersten Last-Kondensator (36) gleich ist dem Verhältnis des Kondensators (39) des Löschungs-Netzwerks (28) zu dem zweiten Last-Kondensator (37).

9. System nach einem der Ansprüche 1 bis 5, wobei der Resonator (27) einen Serienschaltkreis eines Widerstands (26), eines Induktors (25) und eines Kondensators (24) umfasst, wobei der Serienschaltkreis einen ersten Anschluss besitzt, welcher mit dem Eingang des Resonators (27) verbunden ist, und einen zweiten Anschluss besitzt, welcher mit dem Ausgang des Resonators (27) verbunden ist, wobei der Resonator (27) auch einen statischen Kondensator (23) umfasst, welcher parallel zu dem Serienschaltkreis zwischen dem ersten Anschluss und dem zweiten Anschluss verbunden ist.

10. Verfahren zum Löschen eines Anti-Resonanz-Signals (22), umfassend:

- Schaffen eines Resonator-Schaltkreises (27) mit einem Ausgang; und

- Schaffen eines Löschungs-Netzwerkes (28) mit einem Eingang, welcher mit dem Eingang des Resonator-Schaltkreises (27) verbunden ist, und mit einem Ausgang;

**gekennzeichnet durch**,

- Subtrahieren des Signals am Ausgang des Löschungs-Netzwerks (28) von dem Signal am Ausgang des Resonator-Schaltkreises (27), zum Erzeugen einer Subtrahierer-Ausgabe (32),
- wobei die Subtrahierer-Ausgabe (32) ein Resonanz-Signal (21) des Resonators ohne ein Anti-Resonanz-Signal (22) enthält.

11. Verfahren nach Anspruch 10,
wobei das Löschungs-Netzwerk (28) ein Kondensator (39) ist.

12. Verfahren nach Anspruch 10,
wobei eine Kapazität (39) des Löschungs-Netzwerks (28) gleich einer statischen Kapazität (23) des Resonators (27) ist.

**Revendications**

1. Système de résonateur comprenant :

un résonateur (27) comportant une entrée connectée à un signal d'entrée (34) et une sortie ; et
un réseau d'annulation (28) comportant une entrée connectée audit signal d'entrée (34) et comportant une sortie,
**caractérisé par** :

un soustracteur (31) comportant une entrée positive connectée à la sortie dudit résonateur (27) et une entrée négative connectée à la sortie dudit réseau d'annulation (28) et une sortie,
dans lequel une anti-résonance (22) est enlevée de la sortie dudit résonateur (27).

2. Système selon la revendication 1, comprenant en outre une première charge (29) connectée à ladite sortie dudit résonateur (27) et une seconde charge (30) connectée à ladite sortie dudit réseau d'annulation (28).

3. Système selon la revendication 2, comprenant en outre une capacité d'entrée (33) connectée à ladite entrée dudit résonateur (27) et à ladite entrée dudit réseau d'annulation (28).

4. Système selon l'une quelconque des revendications 1, 2 ou 3, dans lequel ledit réseau d'annulation (28)
inclut un condensateur (39) connecté entre ladite entrée dudit réseau d'annulation (28) et ladite sortie dudit réseau d'annulation (28).

5. Système selon l'une quelconque des revendications 1 à 4, dans lequel ledit condensateur (39) dudit réseau d'annulation (28) présente une valeur égale à une capacité statique (23) dudit résonateur (27) et dans lequel les paramètres de ladite première charge (29) et de ladite seconde charge (30) sont égaux.

6. Système selon l'une quelconque des revendications 1 à 5, dans lequel ladite première charge (29) inclut un premier condensateur de charge (36) et ladite seconde charge (30) inclut un second condensateur de charge (37), les capacités de ladite première charge (36) et de ladite seconde charge (37) étant égales.

7. Système selon l'une quelconque des revendications 1 à 5, dans lequel ladite première charge (29) inclut une première résistance de charge (35) et ladite seconde charge (30) inclut une seconde résistance de charge (38) et les résistances de ladite première résistance de charge (35) et de ladite seconde résistance de charge (38) sont égales.

8. Système selon l'une quelconque des revendications 1 à 5, dans lequel ladite première charge (29) inclut seulement un premier condensateur de charge (36) et ladite seconde charge (30) inclut seulement un second condensateur de charge (37), le rapport de la capacité statique (23) du résonateur (27) sur le premier condensateur de charge (36) étant égal au rapport du condensateur (39) du réseau d'annulation (28) sur le second condensateur de charge (37).

9. Système selon l'une quelconque des revendications 1 à 5, dans lequel ledit résonateur (27) inclut un circuit série constitué par une résistance (26), un inducteur (25) et un condensateur (24), ledit circuit série comportant une première borne connectée à ladite entrée dudit résonateur (27) et comportant une seconde borne connectée à une sortie dudit résonateur (27), ledit résonateur (27) incluant également un condensateur statique (23) connecté en parallèle audit circuit série entre ladite première borne et ladite seconde borne.

10. Procédé pour annuler un signal d'anti-résonance (22), comprenant :

la fourniture d'un circuit de résonateur (27) comportant une entrée et une sortie ;
la fourniture d'un réseau d'annulation (28) comportant une entrée connectée audit circuit de résonateur (27) et comportant une sortie,
**caractérisé par** :

la soustraction du signal au niveau de la sortie dudit réseau d'annulation (28) du signal au niveau d'une sortie dudit circuit de résonateur (27) afin de produire une sortie de soustracteur (32),

dans lequel la sortie de soustracteur (32) contient un signal de résonance (21) en provenance dudit résonateur sans un signal d'anti-résonance (22).

11. Procédé selon la revendication 10, dans lequel ledit réseau d'annulation (28) est un condensateur (39).

12. Procédé selon la revendication 10, dans lequel la capacité (39) dudit réseau d'annulation (28) est égale à la capacité statique (23) dudit résonateur (27).

FIGURE 1

PRIOR ART

FIGURE 2

PRIOR ART

FIGURE 3

Signal frequency / Sampling frequency

FIGURE 4

FIGURE 5

Signal frequency / Sampling frequency

FIGURE 6

**FIGURE 7**

Signal frequency / Sampling frequency

**.FIGURE 8**

FIGURE 9

Signal frequency / Sampling frequency

FIGURE 10

$f_r$ – resonance frequency
$f_a$ – anti-resonance frequency

**Figure 11**

**Figure 12**

**Figure 13**

Figure 14

Figure 15

AC Response

Figure 16

AC Response

Figure 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001044790 A
- US 4754242 A
- US 5499003 A
- JP 61157112 A

**Non-patent literature cited in the description**

- *PATENT ABSTRACTS OF JAPAN,* vol. 2000, 19
- *PATENT ABSTRACTS OF JAPAN,* vol. 010, 359